# EUROPÄISCHE PATENTSCHRIFT

(11) **EP 2 435 600 B1**
(45) Veröffentlichungstag und Bekanntmachung des Hinweises auf die Patenterteilung: **31.07.2013**
(21) Anmeldenummer: 10785333.5
(22) Anmeldetag: 06.11.2010
(51) Int. Cl.: C23C 18/54

(54) **VERFAHREN ZUM ABSCHEIDEN EINER FÜR DAS DRAHTBONDEN GEEIGNETEN PALLADIUMSCHICHT AUF LEITERBAHNEN EINER SCHALTUNGSTRÄGERPLATTE UND PALLADIUMBAD ZUR VERWENDUNG IN DEM VERFAHREN**
METHOD FOR DEPOSITING A PALLADIUM LAYER SUITABLE FOR WIRE BONDING ON CONDUCTORS OF A PRINTED CIRCUIT BOARD AND PALLADIUM BATH FOR USE IN SAID METHOD
PROCÉDÉ POUR DÉPOSER UNE COUCHE DE PALLADIUM ADAPTÉE À LA MÉTALLISATION DE FILS, SUR DES PISTES CONDUCTRICES D'UNE PLAQUE PORTE-CIRCUIT ET BAIN DE PALLADIUM À UTILISER POUR METTRE EN OEUVRE LE PROCÉDÉ

(30) Priorität: 10.11.2009 DE 102009053302; 13.03.2010 DE 102010011269
(43) Veröffentlichungstag der Anmeldung: 04.04.2012
(73) Patentinhaber: Doduco GmbH, 75181 Pforzheim (DE)
(72) Erfinder: HEBER, Jochen, 75305 Neuenbürg (DE); MARKA, Erwin, 75203 Königsbach-Stein (DE); MACHT, Walter, 75180 Pforzheim (DE); ÖLSCHLÄGER, Silke, 75217 Birkenfeld (DE)
(74) Vertreter: Twelmeier, Ulrich
(86) Internationale Anmeldenummer: PCT/EP2010/006769
(87) Internationale Veröffentlichungsnummer: WO 2011/057745

(56) Entgegenhaltungen:
- EP-A1- 2 177 646
- EP-A2- 0 512 724

## Beschreibung

Die Erfindung geht aus von einem Verfahren mit den im Oberbegriff des Anspruchs 1 angegebenen Merkmalen. Ein solches Verfahren ist aus der WO 2006/074902 A2 bekannt. Nach dem bekannten Verfahren wird auf Leiterbahnen aus Kupfer, welche sich auf einer organischen oder keramischen Schaltungsträgerplatte befinden, zunächst Nickel aus einem chemischen Nickelbad reduktiv, d. h. außenstromlos, abgeschieden. Anstelle von Nickel kann auch eine Nickellegierung aus einem entsprechenden Nickellegierungsbad außenstromlos abgeschieden werden. Auf die Nickelschicht bzw. auf die Nickellegierungsschicht wird aus einem Palladium-Austauschbad durch Ladungsaustausch eine zwischen 10 nm und 40 nm dünne Palladiumschicht abgeschieden. Das Palladium-Austauschbad besteht üblicherweise aus einer anorganischen oder organischen Säure und aus dem Palladiumsalz dieser Säure sowie aus einer anorganischen Verbindung wenigstens eines der Elemente Kupfer, Thallium, Selen und Tellur, vorzugsweise Kupfersulfat. Der pH-Wert des Palladium-Austauschbades ist kleiner als 1, d. h. das Bad ist stark sauer. Ein Palladium-Austauschbad wird auch als Palladium-Sudbad oder als Palladium-Aktivierungsbad bezeichnet, eine Abscheidung daraus als Sudabscheidung oder Aktivierung.

Auf die Palladiumschicht wird abschließend eine Deckschicht aus Gold mit einer Dicke von weniger als 0,1 µm abgeschieden. Vorzugsweise wird das Gold aus einem Gold-Austauschbad abgeschieden. Die Goldschicht kann durch Abscheidung aus einem chemischen Goldbad autokatalytisch, d. h. durch reduktive Abscheidung, auf eine grö-βere Dicke verstärkt werden.

Das Palladium dient zunächst als Grundlage für das spätere Befestigen von Drähten aus Gold oder Aluminium durch Bonden. Darüber hinaus soll diese Pd-Schicht die Diffusion von Nickel an die Goldoberfläche verhindern, um die Bondfähigkeit zu erhalten. Die Goldschicht soll die Palladiumoberfläche vor chemischen Veränderungen schützen, denen sie aufgrund ihrer hohen katalytischen Reaktionsfähigkeit unterliegen und z. B. den "brown powder"-Effekt nach sich ziehen kann.

Gemäß der Offenbarung in der WO 2006/074902 A2 wurde gefunden, dass die gestellten Anforderungen bezüglich Mehrfachlötbarkeit und Bondbarkeit nur erfüllt werden können, wenn dem Palladiumbad zusätzlich zu dem Palladiumsalz eine anorganische Verbindung wenigstens eines der Elemente Kupfer, Thallium, Selen und Tellur zugefügt wurden, insbesondere Kupfersulfat. Ohne den Zusatz von anorganischen Verbindungen wenigstens eines dieser Elemente zum Palladium-Ladungsaustauschbad wurde keine ausreichende Haftung und Sperrwirkung der Palladiumschicht erreicht.

Auf dem Markt sind Verfahren für das Beschichten von Kupfer-Leiterbahnen auf Schaltungsträgerplatten bekannt, nach denen zunächst Palladium aus einem üblichen Palladium-Austauschbad auf das Kupfer abgeschieden wird. Darauf wird Palladium aus einem chemischen (reduktiven) Palladiumbad abgeschieden und abschließend wird als Deckschicht eine Goldschicht abgeschieden. Das bekannte Verfahren führt zu einem Schichtaufbau, der sich gemäß Herstellerempfehlung zwar zum Löten, nicht aber zum Bonden von Drähten aus Gold und Aluminium eignet.

Am Markt ist auch ein Verfahren bekannt, das zu bondfähigen Oberflächen auf Kupfer-leiterbahnen von Schaltungsträgerplatten führen soll. Es ist so ausgestaltet, dass auf die Kupfer-Leiterbahnen zunächst Palladium aus einem üblichen Palladium-Aktivierungsbad abgeschieden wird. Darauf wird eine Nickelschicht aus einem chemischen (reduktiven) Nickelbad abgeschieden. Auf die Nickelschicht wird eine weitere Palladiumschicht aus einem üblichen Palladium-Aktivierungsbad abgeschieden, und diese Palladiumschicht wird durch Abscheiden von Palladium aus einem chemischen (reduktiven) Palladiumbad verstärkt. Abschließend wird die Palladiumoberfläche durch eine Sudgoldschicht geschützt. Dieses bekannte Verfahren ist außerordentlich aufwendig.

Der vorliegenden Erfindung liegt die Aufgabe zugrunde, ein alternatives Verfahren anzugeben, nach welchem mit mäßigem Aufwand bondfähige Palladiumschichten auf Leiterbahnen von Schaltungsträgerplatten abgeschieden werden können, insbesondere auf Leiterbahnen aus Kupfer.

Diese Aufgabe wird gelöst durch ein Verfahren mit den im Anspruch 1 angegebenen Merkmalen. Ein zum Durchführen des Verfahrens besonders geeignetes Palladiumbad ist Gegenstand des Anspruchs 10. Vorteilhafte Weiterbildungen der Erfindung sind Gegenstand der abhängigen Ansprüche.

Erfindungsgemäß werden Palladiumschichten auf Leiterbahnen von Schaltungsträgerplatten, insbesondere auf Leiterbahnen aus Kupfer, durch Ladungsaustausch aus einem Palladium-Austauschbad abgeschieden, welches einen organischen Glanzbildner enthält.

Damit wird dem Fachmann neben dem aus der WO 2006/074902 A2 bekannten Verfahren ein weiteres Verfahren an die Hand gegeben, um auf Leiterbahnen von Schaltungsträgerplatten eine zum Bonden geeignete Palladiumschicht abzuscheiden. Dieses Verfahren hat folgende weitere Vorteile:
- Die Palladiumschicht kann nicht nur auf Leiterbahnen abgeschieden werden, die zuvor mit Nickel beschichtet worden sind, sondern kann auch unmittelbar auf eine Leiterbahn aus Kupfer abgeschieden werden.
- Eine im Stand der Technik bekannte Zwischenschicht aus Nickel ist entbehrlich.
- Weil eine Zwischenschicht aus Nickel entbehrlich ist, eignet sich die Palladiumbeschichtung auch für Hochfrequenzanwendungen, für welche Nickel wegen seiner magnetischen Eigenschaft nicht infrage kommt.
- Die Palladiumschichten, welche aus dem einen organischen Glanzbildner enthaltenden Austausch-Palladiumbad abgeschieden werden, erweisen sich als au-βerordentlich dicht, feinkörnig und gleichmäßig. Im Gegensatz zu einem herkömmlichen Pd-Aktivierungsbad wird so eine gut geeignete Grundlage für eine weitere Verstärkung mit Palladium aus einem reduktiven Pd-Bad geschaffen. Eine solche reduktive Palladiumabscheidung aus einem chemischen Palladiumbad erfolgt vorzugsweise in einer Dicke von 0,05 µm bis 0,5 µm, insbesondere von 0,1 µm bis 0,3 µm. Das ist mehr als die Dicke der darunter liegenden Palladiumschicht, welche aus einem erfindungsgemäßen Austauschpalladiumbad abgeschieden wurde, und ist für das Befestigen von Drähten aus Gold oder Aluminium durch Bonden besonders geeignet und als Weiterbildung der Erfindung vorteilhaft.
- Zweckmäßigerweise wird der pH-Wert des erfindungsgemäßen Bades kleiner als 4 gehalten. Besonders bevorzugt ist es, das erfindungsgemäße Bad bei einem pH-Wert von 2 zu betreiben.
- Das erfindungsgemäße Palladium-Austauschbad ist hinreichend stabil.

Als organische Glanzbildner eignen sich insbesondere Verbindungen aus der im Anspruch 2 angegebenen Gruppe von Verbindungen. Besonders bevorzugt ist als Glanzbildner 3-(1- Pyridinio)-1-Propansulfonat, welches sich für den Fall ergibt, dass in der allgemeinen Formel die Reste R¹ bis R⁵ Wasserstoff sind, der Rest R⁶ -CH₂-CH₂-CH₂- ist und in welcher X = SO₂ ist. In Abwesenheit dieser Verbindung erscheint das aus dem Austauschbad abgeschiedene Palladium vor allem in und an den Löchern einer Schaltungsträgerplatte dunkel bis schwarz, was auf eine poröse bis schwammige Abscheidung schließen lässt. Bei Anwesenheit der organischen Verbindung im Palladium-Austauschbad wird hingegen eine deutlich bessere, helle, gleichmäßige und optisch ansprechende Palladiumschicht erzeugt.

Das Bad enthält den organischen Glanzbildner zweckmäßigerweise in einer Konzentration von 0,01 bis 50 g pro Liter, vorzugsweise in einer Konzentration von 1 bis 10 g pro Liter. Besonders gute Ergebnisse wurden erzielt, wenn das 3-(1- Pyridinio)-1-Propansulfonat in einer Konzentration von 3 bis 6 g pro Liter im Palladium-Austauschbad enthalten war. Bei geringeren Konzentrationen nimmt die Wirksamkeit des Glanzbildners im Palladium-Austauschbad ab. Mit zunehmender Konzentration des Glanzbildners verringert sich die Abscheiderate, weshalb die Konzentration des organischen Glanzbildners 50 g pro Liter nicht überschreiten sollte.

Das Palladium ist in dem erfindungsgemäßen Palladium-Austauschbad zweckmäßigerweise in einer Menge von 150 mg pro Liter bis 250 mg pro Liter enthalten, vorzugsweise als Palladiumchloridlösung. Niedrigere Konzentrationen führen dazu, dass zum Erreichen der angestrebten Schichtdicke die Verweildauer im Bad zunimmt oder unverhältnismäßig lang wird. Deshalb sollte die Palladiumkonzentration nicht kleiner als 150 mg pro Liter sein. Mit zunehmender Konzentration des Palladiums erreicht man höhere Abscheideraten und kann auch größere Schichtdicken bis über 50 nm erreichen. Dabei nimmt dann allerdings auch die Porosität der Palladiumschicht zu und die Einheitlichkeit und Gleichmäßigkeit der Palladiumschicht ab und die unter der Palladiumschicht liegende Leiterbahn wird durch den Austausch des unedleren Metalls, aus welchem sie besteht, gegen das edlere Palladium unter Umständen zu stark angegriffen. Deshalb wird es bevorzugt, die Konzentration des Palladiums im Austauschbad auf 250 mg pro Liter zu begrenzen.

Als weitere Glanzbildner eignen sich Benzaldehyde, insbesondere Benzaldehyd-2-sulfonsäure in einer Konzentration von 0,1 bis 50 g pro Liter, vorzugsweise ca. 1 g pro Liter.

Das Palladium liegt im Palladium-Austauschbad vorzugsweise als Palladiumchlorid vor und ist in Salzsäure gelöst. Es ist aber auch möglich, das Palladium-Austauschbad mit anderen Salzen zu bilden, z. B. mit Palladiumsulfat, aufgelöst in Schwefelsäure, oder mit Palladiumphosphat, aufgelöst in Phosphorsäure, oder mit Palladiumacetat, aufgelöst in Essigsäure. Die Verwendung von Palladiumchlorid in Salzsäure ist jedoch bevorzugt, weil sich ein solches Bad als besonders stabil erwiesen hat.

Zur Stabilisierung enthält das erfindungsgemäße Palladium-Austauschbad vorzugsweise noch einen anorganischen Komplexbildner, und zwar in einer Menge von bis zu 150 g pro Liter, vorzugsweise in einer Menge von 30 bis 80 g pro Liter. Das Bad ist gegen Änderungen der Konzentration des anorganischen Komplexbildners nicht sehr empfindlich, jedoch nimmt die Abscheiderate mit zunehmender Konzentration des Komplexbildners ab, weshalb die Konzentration 150 g pro Liter nicht überschreiten sollte, vorzugsweise 80 g pro Liter nicht überschreiten sollte.

Besonders geeignet als anorganische Komplexbildner sind Ammoniumsalze, wobei deren Anion vorzugsweise dasselbe sein sollte wie beim Palladiumsalz. Wenn also, wie bevorzugt, Palladiumchlorid in dem Palladium-Austauschbad verwendet wird, dann sollte der anorganische Komplexbildner ebenfalls ein Chlorid, insbesondere Ammoniumchlorid sein. Wird Palladiumsulfat als Palladiumsalz verwendet, dann empfiehlt sich als anorganischer Komplexbildner ebenfalls ein Sulfat, insbesondere Ammoniumsulfat. Wird als Palladiumsalz Palladiumacetat verwendet, dann sollte der anorganische Komplexbilder ebenfalls ein Acetat sein, insbesondere Ammoniumacetat, usw.... Es wäre auch möglich, für den anorganischen Komplexbildner ein anderes Kation als Ammonium zu verwenden, z. B. Natrium oder Kalium, doch erreicht man mit Ammoniumsalzen eine etwas bessere Stabilität des Bades.

Es wurde gefunden, dass der Zusatz eines organischen Komplexbildners die Abscheidung des Palladiums aus dem Palladium-Austauschbad weiter verbessern kann. Insbesondere kann die Neigung dieser Palladiumbäder, auf größeren zusammenhängenden Flächen eines unedleren Substrates eine stellenweise fleckige oder wolkige, dunklere Abscheidung zu bewirken, verringert werden. Diese günstige Wirkung des organischen Komplexbildners unterstützt die günstige Wirkung des erfindungsgemäß verwendeten organischen Glanzbildners zur Erzielung einer gleichmäßig hellen, dichten und feinkörnigen Palladiumabscheidung. Außerdem hat es sich gezeigt, dass der organische Komplexbildner die Stabilität des Bades insbesondere bei größerem Durchsatz von Schaltungsträgerplatten durch das Bad deutlich verbessert.

Als organische Komplexbildner eignen sich insbesondere Karbonsäuren, Amine, EDTA und EDTA-Abkömmlinge. Als besonders geeignet hat sich Diethylentriamin erwiesen, insbesondere in einer Konzentration zwischen 0,01 ml pro Liter und 5 ml pro Liter. Mit zunehmender Konzentration des organischen Komplexbildners im Palladium-Austauschbad verringert sich die Abscheiderate.

Das Palladium-Austauschbad wird beim Abscheiden zweckmäßigerweise auf einer Temperatur zwischen Raumtemperatur und 60°C gehalten, vorzugsweise bei einer Temperatur im Bereich von 35°C bis 50°C. Dieser Bereich hat sich als besonders geeignet erwiesen. Mit der angegebenen Temperatur und einem Bad in der bevorzugten Zusammensetzung kann man die angestrebte Schichtdicke, welche vorzugsweise 25 nm bis 35 nm beträgt und nicht mehr als 50 nm betragen sollte, innerhalb von 5 Minuten abscheiden. Vorzugsweise begrenzt man den Abscheidevorgang auf 2 bis 3 Minuten.

Es wurde bereits erwähnt, dass das erfindungsgemäße Palladium-Austauschbad vorzugsweise auf einen pH-Wert von 2 eingestellt werden soll. Bei einem salzsauren Bad mit Palladium als Palladiumchlorid und mit Ammoniumchlorid als anorganischem Komplexbildner kann man den pH-Wert durch Zugabe von Salzsäure oder Ammoniak einstellen. Bei höheren pH-Werten als pH = 2 wird das Palladium stärker komplexiert, d. h., dass weniger freies Palladium zur Abscheidung zur Verfügung steht. Mit zunehmendem pH-Wert sinkt demnach die Abscheiderate. Bei einem pH-Wert, der größer als 4 ist, findet keine nennenswerte Abscheidung mehr statt.

Die aus dem Palladium-Austauschbad abgeschiedene Palladiumschicht kann durch Abscheiden weiteren Palladiums mit einem Reduktionsmittel aus einem chemischen Palladiumbad verstärkt werden. Für eine solche Verstärkung der Palladiumschicht ist die aus dem erfindungsgemäßen Palladium-Austauschbad abgeschiedene Palladiumschicht eine besonders geeignete Grundlage, weil sie infolge der Verwendung des organischen Glanzbildners außerordentlich dicht, feinkörnig und gleichmäßig ist. Insbesondere benötigt man unter der durch reduktive Abscheidung von Palladium erzeugten Palladiumschicht keine Nickelschicht als Diffusionssperrschicht gegen die Diffusion von Kupfer in die Palladiumschicht. Eine Nickelschicht kann sich unter der aus einem Palladium-Austauschbad abgeschiedenen Palladiumschicht dann empfehlen, wenn diese nicht durch Abscheiden weiteren Palladiums aus einem reduktiven Palladiumbad verstärkt ist. Durch die Verstärkung sind Palladiumschichten möglich, die mehrere µm dick sind. Für die Verwendung zum Bonden sind aber Palladiumschichten, die mehrere µm dick sind, wirtschaftlich nicht mehr sinnvoll. Der für das Bonden bevorzugte Bereich der Palladiumschichtdicke beträgt 50 nm bis 500 nm.

Geeignete chemische (reduktive) Bäder zum Abscheiden von Palladium sind bekannt. Ein gut geeignetes Bad hat folgende Zusammensetzung:
0,5 bis 3 g pro Liter Palladium als Chlorid, Sulfat, Azetat, Phosphat oder dergleichen Salz in Lösung gebracht bzw. als Komplex gebunden, z. B. als Chlorokomplex, Aminkomplex, Nitritokomplex oder dergleichen.
Als Reduktionsmittel 5 bis 50 g pro Liter Natriumhypophosphit oder
   1 bis 50 g pro Liter Natriumformiat oder
   1 bis 50 g pro Liter Ameisensäure.
Anorganische Komplexierungsmittel, z. B. Natriumzitrat, Salze der Malonsäure, Salze der Bernsteinsäure, Kaliumphosphat, Kaliumdihydrogenphosphat, Ammoniumsulfat.
Organische Komplexierungsmittel, z. B. EDTA, EDTA-Derivate, Amine wie z. B. Triethanolamin, Tris-(2-aminoethyl)-amine, Diethylentriamin, Triethylentetramin, 1,3-Diaminopropan, jeweils einzeln oder in Kombination.

Darüber hinaus kann das chemische Palladiumbad weitere Bestandteile, vor allem Stabilisatoren und Beschleuniger enthalten, die dem Fachmann z. B. aus der EP 0 698 130 B1 bekannt sind.

Mit einem solchen chemischen Palladiumbad wird bei Temperaturen zwischen 40°C und 90°C, insbesondere bei einer Temperatur von ca. 70°C, gearbeitet. Je nach der gewünschten Schichtdicke kommen Beschichtungszeiten von 30 Minuten bis 60 Minuten infrage. Die bekannten chemischen Palladiumbäder arbeiten zumeist im schwach sauren bis schwach alkalischen Bereich. In chemischen Palladiumbädern, wie sie vorstehend beschrieben wurden, kann mit einem pH-Wert von 8 gearbeitet werden.

Nachfolgend sind die wichtigsten Schritte für ein beispielhaftes Verfahren zur Palladiumabscheidung beschrieben, wobei ein chemisches Palladiumbad wie oben beschrieben verwendet werden kann und ein Palladium-Austauschbad mit 150 bis 250 mg pro Liter Palladium als Palladiumchlorid, mit 50 g pro Liter Ammoniumchlorid, mit 3 g pro Liter 3-(1 Pyridinio)-1-Propansulfonat und mit 1 bis 5 ml pro Liter Diethylentriamin verwendet wird, mit welchem bei 35°C bis 50°C und einem pH-Wert von 2 gearbeitet werden kann.

Folgende Schritte können bei der Behandlung einer Schaltungsträgerplatte mit Leiterbahnen aus Kupfer mit diesen Bädern zur Anwendung kommen:
1. Entfetten in einem leicht sauren Entfettungsbad
2. Spülen mit Wasser
3. Eintauchen in eine Ätzlösung zur Aktivierung der Kupferoberfläche
4. Spülen
5. Beschichten mit Palladium in einem erfindungsgemäßen Palladium-Austauschbad
6. Eintauchen in eine verdünnte Salzsäurelösung zum Beseitigen von Fremdkeimen von der Palladiumoberfläche
7. Spülen mit Wasser
8. Abscheiden von Palladium in einem chemischen (reduktiven) Palladiumbad
9. Eintauchen in eine Sparspüle, um an der Schaltungsträgerplatte haftende Reste des Palladiumbades zu sammeln und ihr Verschleppen in folgende Bäder zu verhindern
10. Spülen mit Wasser
11. Abscheiden eines Goldflashes
12. Eintauchen in eine Sparspüle
13. Spülen mit Wasser
14. Trocknen.

Das Abscheiden eines Goldflashes, dessen Dicke z. B. 20 nm bis 30 nm betragen kann, ist zum Schutz von Palladiumoberflächen allgemein üblich und dem Fachmann bekannt. Das Gold wird vorzugsweise aus einem Austauschbad abgeschieden.

## Patentansprüche

1. Verfahren zum Abscheiden von Palladiumschichten, welche zum Bonden geeignet sind, auf Leiterbahnen von Schaltungsträgerplatten, durch Abscheiden von Palladium aus einem Palladium-Austauschbad
**dadurch gekennzeichnet, dass** ein Austausch-Palladiumbad verwendet wird, welches einen organischen Glanzbildner enthält.

2. Verfahren nach Anspruch 1, **dadurch gekennzeichnet, dass** der organische Glanzbildner aus der Gruppe der folgenden Verbindungen ausgewählt ist:
(a) 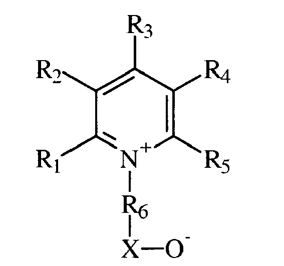 worin
R¹ bis R⁵ jeweils ein Wasserstoffatom oder Halogenatom oder eine Formyl-, Karbamoyl-, C₁₋₄ Alkyl-, Amino-, Phenyl- oder Benzylgruppe bedeuten, wobei der Alkyl-, Phenyl- und Benzyl-Anteil wahlweise durch eine oder mehrere Hydroxylgruppen oder Aminogruppen oder durch Halogenatome ersetzt sein kann,
R⁶ ein von einem gesättigten oder ungesättigten aliphatischen Kohlenwasserstoff abgeleitetes Radikal mit 1-6 C-Atomen ist, wobei das Radikal substituiert sein kann,und X eine SO₂-Gruppe oder CO-Gruppe ist,
(b) Benzaldehyde

3. Verfahren nach Anspruch 2, **dadurch gekennzeichnet, dass** als Glanzbildner 3- (1-Pyridinio)-1-Propansulfonat oder Benzaldehyd-2-sulfonsäure verwendet wird.

4. Verfahren nach einem der vorstehenden Ansprüche, **dadurch gekennzeichnet, dass** in dem Palladium-Austauschbad die Konzentration des organischen Glanzbildners auf einen Wert zwischen 0,01 g pro Liter und 50 g pro Liter eingestellt und aufrechterhalten wird.

5. Verfahren nach Anspruch 4, **dadurch gekennzeichnet, dass** das 3-(1- Pyridinio)-1-Propansulfonat in einer Konzentration von 3 g pro Liter bis 6 g pro Liter bzw. die Benzaldehyd-2-sulfonsäure in einer Konzentration von 1 g pro Liter verwendet wird.

6. Verfahren nach einem der vorstehenden Ansprüche, **dadurch gekennzeichnet, dass** das Palladium-Austauschbad beim Abscheiden auf einer Temperatur zwischen Raumtemperatur und 60°C gehalten wird.

7. Verfahren nach einem der vorstehenden Ansprüche, **dadurch gekennzeichnet, dass** das Palladium-Austauschbad bei einem pH-Wert kleiner als 4 betrieben wird.

8. Verfahren nach einem der vorstehenden Ansprüche, **dadurch gekennzeichnet, dass** die Verweildauer der Schaltungsträgerplatte in dem Palladium-Austauschbad nicht mehr als 5 Minuten beträgt.

9. Verfahren nach einem der vorstehenden Ansprüche, **dadurch gekennzeichnet, dass** nach der Abscheidung von Palladium aus dem Palladium-Austauschbad eine Abscheidung von Palladium aus einem chemischen (reduktiven) Palladiumbad erfolgt.

10. Palladium-Austauschbad zur Verwendung in einem Verfahren nach einem der vorstehenden Ansprüche, welches das Palladium als Palladiumsalz in einer wässrigen, sauren Lösung enthält, **dadurch gekennzeichnet, dass** es einen Glanzbildner aus der Gruppe der folgenden Verbindungen enthält:
(a) 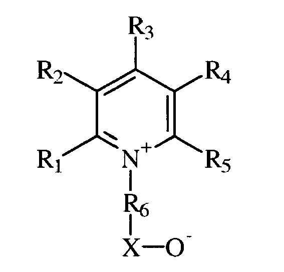 worin
R¹ bis R⁵ jeweils ein Wasserstoffatom oder Halogenatom oder eine Formyl-, Karbamoyl-, C₁₋₄ Alkyl-, Amino-, Phenyl- oder Benzylgruppe bedeuten, wobei der Alkyl-, Phenyl- und Benzyl-Anteil wahlweise durch eine oder mehrere Hydroxylgruppen oder Aminogruppen oder durch Halogenatome ersetzt sein kann,
R⁶ ein von einem gesättigten oder ungesättigten aliphatischen Kohlenwasserstoff abgeleitetes Radikal mit 1-6 C-Atomen ist, wobei das Radikal substituiert sein kann,und X eine SO₂-Gruppe oder CO-Gruppe ist,
(b) Benzaldehyde.

11. Bad nach Anspruch 10, **dadurch gekennzeichnet, dass** es das Palladium in einer Menge von 150 mg pro Liter bis 250 mg pro Liter enthält.

12. Bad nach Anspruch 10 oder 11, **dadurch gekennzeichnet, dass** es das Palladium als Palladiumchlorid enthält.

13. Bad nach einem der Ansprüche 10 bis 12, **dadurch gekennzeichnet, dass** es zusätzlich einen anorganischen Komplexbildner in einer Menge von bis zu 150 g pro Liter enthält.

14. Bad nach Anspruch 13, **dadurch gekennzeichnet, dass** es 30 bis 80 g pro Liter des anorganischen Komplexbildners enthält.

15. Bad nach Anspruch 13 oder 14, **dadurch gekennzeichnet, dass** der anorganische Komplexbildner ein Ammoniumsalz, insbesondere Ammoniumchlorid ist.

16. Bad nach einem der Ansprüche 10 bis 15, **dadurch gekennzeichnet, dass** es als organischen Komplexbildner Diethylentriamin in einer Konzentration zwischen 0,01 ml pro Liter und 5 ml pro Liter enthält.

## Claims

1. Method for depositing palladium layers suitable for bonding on conductors of printed circuit boards by depositing palladium from a palladium exchange bath, **characterized in that** a palladium exchange bath containing an organic brightener is used.

2. Method according to claim 1, **characterized in that** the organic brightener is selected from the group of the following compounds:
(a) 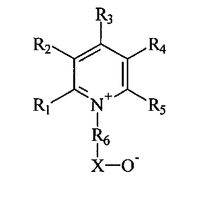 in which
R₁ to R₅ each is a hydrogen atom or halogen atom or a formyl, carbamoyl, C₁₋₄ alkyl, amino, phenyl or benzyl group, in which the alkyl, phenyl, and benzyl fraction can optionally be replaced by one or more hydroxyl groups or amino groups or by halogen atoms,
R₆ is a radical having 1-6 C atoms that is derived from a saturated or unsaturated aliphatic hydrocarbon, in which the radical can be substituted and X is an SO₂ group or a CO group,
(b) benzaldehydes

3. Method according to claim 2, **characterized in that** 3-(1-pyridinio)-1-propane sulfonate or benzaldehyde-2-sulfonic acid is used as brightener.

4. Method according to any of the preceding claims, **characterized in that** the concentration of the organic brightener in the palladium exchange bath is adjusted to and maintained at a value between 0.01 g per liter and 50 g per liter.

5. Method according to claim 4, **characterized in that** the 3-(1-pyridinio)-1-propane sulfonate is used at a concentration of 3 g per liter to 6 g per liter or the benzaldehyde-2-sulfonic acid, respectively, is used at a concentration of 1 g per liter.

6. Method according to any of the preceding claims, **characterized in that** the palladium exchange bath is maintained at a temperature between room temperature and 60°C during the deposition.

7. Method according to any of the preceding claims, **characterized in that** the palladium exchange bath is operated at a pH value of less than 4.

8. Method according to any of the preceding claims, **characterized in that** the dwell time of the printed circuit board in the palladium exchange bath is no more than 5 minutes.

9. Method according to any of the preceding claims, **characterized in that** a deposition of palladium from a chemical (reductive) palladium bath follows after the deposition of palladium from the palladium exchange bath.

10. Palladium exchange bath for use in a method according to any of the preceding claims, containing the palladium in the form of a palladium salt in an aqueous acidic solution, **characterized in that** it contains a brightener from the group of the following compounds:
(a) 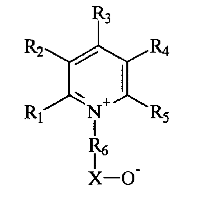 in which
R₁ to R₅ each is a hydrogen atom or halogen atom or a formyl, carbamoyl, C₁₋₄ alkyl, amino, phenyl or benzyl group, in which the alkyl, phenyl, and benzyl fraction can optionally be replaced by one or more hydroxyl groups or amino groups or by halogen atoms,
R₆ is a radical having 1-6 C atoms that is derived from a saturated or unsaturated aliphatic hydrocarbon, in which the radical can be substituted and X is an SO₂ group or a CO group,
(b) benzaldehydes.

11. Bath according to claim 10, **characterized in that** it contains the palladium in an amount of 150 mg per liter to 250 mg per liter.

12. Bath according to claim 10 or 11, **characterized in that** it contains the palladium in the form of palladium chloride.

13. Bath according to any one of the claims 10 to 12, **characterized in that** it contains, in addition, an inorganic complexing agent in an amount of up to 150 g per liter.

14. Bath according to claim 13, **characterized in that** it contains 30 to 80 g of the inorganic complexing agent per liter.

15. Bath according to claim 13 or 14, **characterized in that** the inorganic complexing agent is an ammonium salt, particularly ammonium chloride.

16. Bath according to any of the claims 10 to 15, **characterized in that** it contains diethylene triamine as organic complexing agent at a concentration between 0.01 ml per liter and 5 ml per liter.

## Revendications

1. Procédé pour le dépôt de couches de palladium, qui sont appropriées à la liaison, sur des pistes conductrices d'une plaque porte-circuit par dépôt de palladium à partir d'un bain d'échange de palladium, **caractérisé en ce qu'**on utilise un bain d'échange de palladium qui contient un brillanteur organique.

2. Procédé selon la revendication 1, **caractérisé en ce que** le brillanteur organique est choisi dans le groupe des composés suivants :
(a) 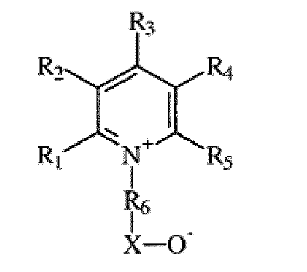 où
R¹ à R⁵ signifient à chaque fois un atome d'hydrogène ou un atome d'halogène ou un groupe formyle, carbamoyle, C₁₋₄-alkyle, amino, phényle ou benzyle, où la partie alkyle, phényle et benzyle peut éventuellement être remplacée par un ou plusieurs groupes hydroxyle ou amino ou par des atomes d'halogène,
R⁶ représente un radical dérivé d'un hydrocarbure aliphatique saturé ou insaturé comprenant 1-6 atomes de carbone, le radical pouvant être substitué, et X représente un groupe SO₂ ou CO,
(b) les benzaldéhydes.

3. Procédé selon la revendication 2, **caractérisé en ce qu'**on utilise, comme brillanteur, du 3-(1-pyridinio)-1-propanesulfonate ou de l'acide benzaldéhyde-2-sulfonique.

4. Procédé selon l'une quelconque des revendications précédentes, **caractérisé en ce que** la concentration en brillanteur organique dans le bain d'échange de palladium est réglée et maintenue à une valeur entre 0,01 g par litre et 50 g par litre.

5. Procédé selon la revendication 4, **caractérisé en ce que** le 3-(1-pyridinio)-1-propanesulfonate est utilisé en une concentration de 3 g par litre à 6 g par litre ou, selon le cas, l'acide benzaldéhyde-2-sulfonique est utilisé en une concentration de 1 g par litre.

6. Procédé selon l'une quelconque des revendications précédentes, **caractérisé en ce que** le bain d'échange de palladium est maintenu lors du dépôt à une température entre la température ambiante et 60°C.

7. Procédé selon l'une quelconque des revendications précédentes, **caractérisé en ce que** le bain d'échange de palladium est exploité à un pH inférieur à 4.

8. Procédé selon l'une quelconque des revendications précédentes, **caractérisé en ce que** la durée de séjour de la plaque porte-circuit dans le bain d'échange de palladium n'est pas supérieure à 5 minutes.

9. Procédé selon l'une quelconque des revendications précédentes, **caractérisé en ce qu'**un dépôt de palladium a lieu à partir d'un bain de palladium chimique (réducteur) après le dépôt de palladium à partir du bain d'échange de palladium.

10. Bain d'échange de palladium destiné à une utilisation dans un procédé selon l'une quelconque des revendications précédentes, qui contient le palladium sous forme de sel de palladium dans une solution aqueuse, acide, **caractérisé en ce qu'**il contient un brillanteur du groupe des composés suivants :
(a) 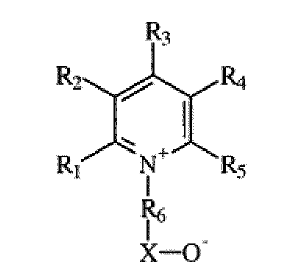 où
R¹ à R⁵ signifient à chaque fois un atome d'hydrogène ou un atome d'halogène ou un groupe formyle, carbamoyle, C₁₋₄-alkyle, amino, phényle ou benzyle, où la partie alkyle, phényle et benzyle peut éventuellement être remplacée par un ou plusieurs groupes hydroxyle ou amino ou par des atomes d'halogène,
R⁶ représente un radical dérivé d'un hydrocarbure aliphatique saturé ou insaturé comprenant 1-6 atomes de carbone, le radical pouvant être substitué, et X représente un groupe SO₂ ou CO,
(b) les benzaldéhydes.

11. Bain selon la revendication 10, **caractérisé en ce qu'**il contient le palladium en une quantité de 150 mg par litre à 250 mg par litre.

12. Bain selon la revendication 10 ou 11, **caractérisé en ce qu'**il contient le palladium sous forme de chlorure de palladium.

13. Bain selon l'une quelconque des revendications 10 à 12, **caractérisé en ce qu'**il contient en plus un complexant inorganique en une quantité allant jusqu'à 150 g par litre.

14. Bain selon la revendication 13, **caractérisé en ce qu'**il contient 30 à 80 g par litre du complexant inorganique.

15. Bain selon la revendication 13 ou 14, **caractérisé en ce que** le complexant inorganique est un sel d'ammonium, en particulier le chlorure d'ammonium.

16. Bain selon l'une quelconque des revendications 10 à 15, **caractérisé en ce qu'**i contient, comme complexant organique, de la diéthylènetriamine en une concentration entre 0,01 ml par litre et 5 ml par litre.
